(19) Europäisches Patentamt

European Patent Office

Office européen des brevets

(11) **EP 1 734 653 A1**

(12) **EUROPEAN PATENT APPLICATION**

(43) Date of publication:
**20.12.2006 Bulletin 2006/51**

(51) Int Cl.:
*H03F 3/217* (2006.01)  *H03F 1/30* (2006.01)
*H03F 1/32* (2006.01)  *H03F 1/34* (2006.01)

(21) Application number: **06012404.7**

(22) Date of filing: **16.06.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.06.2005 KR 20050051659**

(71) Applicant: **Samsung Electronics Co., Ltd.**
**Yeongtong-gu**
**Suwon-si, Gyeonggi-do (KR)**

(72) Inventors:
 • **Lee, Jae-Sup**
 **Yeongtong-gu**
 **Suwon-si**
 **Gyeonggi-do (DE)**

 • **Kim, Tae-Wook**
 **Yeongtong-gu**
 **Suwon-si**
 **Gyeonggi-do (DE)**
 • **Kang, Hyun-Il**
 **Yeongtong-gu**
 **Suwon-si**
 **Gyeonggi-do (DE)**
 • **Baek, Dong-Hyun**
 **Yeongtong-gu**
 **Suwon-si**
 **Gyeonggi-do (DE)**

(74) Representative: **Grünecker, Kinkeldey,**
 **Stockmair & Schwanhäusser**
 **Anwaltssozietät**
 **Maximilianstrasse 58**
 **80538 München (DE)**

(54) **High efficiency power amplifier**

(57) A high efficiency power amplifier with a precise duty cycle is provided for use in a driver or pre-power amplifier of a Radio Frequency (RF) system. The high efficiency power amplifier with an inverter configured by one pair of Metal Oxide Semiconductor (MOS) transistors (M11,M12) includes a feedback path (R1) for adjusting an input voltage in response to an output voltage between input and output terminals of the inverter and correcting an operation time point of the MOS transistors (M11,M12) configuring the inverter. The high efficiency power amplifier can be used for a high efficiency driver to automatically correct duty cycle distortion. When the high efficiency power amplifier is placed in a front stage of various RF power amplifiers, it can be used for a pre-amplifier capable of increasing the efficiency of the RF power amplifier.

FIG.1

**EP 1 734 653 A1**

**Description**

**BACKGROUND OF THE INVENTION**

1. Field of the Invention

The present invention generally relates to a power amplifier for use in a Radio Frequency (RF) system, and more particularly to a high efficiency power amplifier for compensating for duty cycle distortion.

2. Description of the Related Art

Recent Radio Frequency (RF) systems use a high efficiency power amplifier for stably transmitting high speed data and lengthening a usage time. Research is being conducted to implement an RF system with the high efficiency power amplifier in a small size. For this reason, monolithic microwave integrated circuit technology and Complementary Metal Oxide Semiconductor (CMOS) technology are attracting interest. The monolithic microwave integrated circuit technology is exploited to manufacture various passive and active devices on one semiconductor substrate in a batch process. The CMOS technology can implement various logic devices and high frequency RF analog circuits in one chip.
Integration technology using the CMOS is unstable due to deterioration in high frequency characteristics and a parasitic signal between components. However, because an increased number of devices can be gradually integrated on a CMOS substrate with the rapid progress of technology, it is expected that a high frequency RF system will be able to be integrated on one CMOS substrate within several years.
For this, research is being conducted to integrate a power amplifier module on the CMOS substrate. Because of problems such as substrate-related loss, thermal occurrence, power loss of passive devices, the use of conventional power amplifiers using LC matching, an on-chip spiral transformer structure, a CMOS differential push-pull structure, and so on, the efficiency of a power amplifier is gradually decreasing.
To address these problems, a Distributed Active Transformer (DAT) structure has been proposed which is robust to a breakdown voltage and has better thermal conductivity, and is easily implemented on an on-chip CMOS. However, the performance of the DAT structure is degraded when the efficiency of a power amplifier is low due to a coupling coefficient, current runaway phenomenon occurs, and an unbalanced input signal is generated due to a problem in input coupling.
Thus, an improved DAT structure has been proposed which can optimize efficiency and power by increasing a coupling coefficient causing a problem in efficiency. In this case, an input signal of irregular duty (or an unbalanced input signal) reduces the efficiency. That is, because all the various power amplifiers as described above are significantly affected by the duty (or balance) of a switched input signal, a pre-power amplifier or driver is additionally provided in a front stage of each power amplifier such that the duty of the pre-pwer amplifier or driver is maintained while the input signal is amplified.
Conventionally, the pre-power amplifier or driver itself is used as an RF switching amplifier, and is provided in the front stage of the high power amplifier. The pre-power amplifier or driver transforms an input signal of a sine wave into a square wave of sufficient magnitude approximating a duty ratio of 50 % and provides the square wave to the power amplifier.

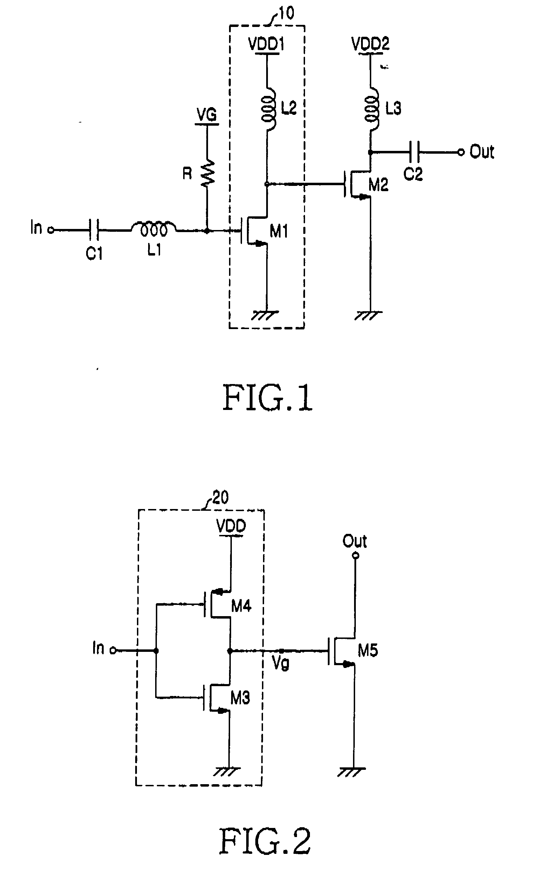

FIG. 1 illustrates a structure of a conventional common source driver. The structure of FIG. 1 is configured to output an input signal as a switching signal of a well-balanced voltage, and is actually applied to a CMOS power amplifier for use in a 2.4GHz Bluetooth application.
As illustrated in FIG. 1, capacitors C1 and C2 for eliminating low frequency noise are serially connected to input and output terminals, and inverters consisting of MOS transistors M1 and M2 and inductors L2 and L3 are serially connected. The inductors L2 and L3 function as a pump in a desired frequency band and amplify an input signal. Because a correct duty ratio may not be maintained through the above-described devices, a bias voltage VG is applied to a gate of the MOS transistor M1 of a front-stage inverter 10 through a resistor R. A bias voltage VDD1 is applied to a drain of the MOS transistor M1 through the inductor L2. The bias voltage supplied to the drain of the MOS transistor M1 is also applied to a gate of the rear-stage MOS transistor M2.
Since the additional bias voltages VG and VDD 1 are required to apply the external bias, the system's burden increases. Although the external bias voltages are applied, a duty cycle ratio cannot be correctly maintained at 50:50 because various environmental factors such as a mismatch, a process variation, a temperature variation in operation, and so on, cannot be coped with. When a large number of passive devices are used, power loss increases, thereby lowering the efficiency. Because the structure uses an inductor, its size increases. When an operation signal swings between negative and positive voltages due to the pumping effect, a dielectric thin film of the MOS transistor frequently destructs, thereby lowering the reliability.
FIG 2 illustrates a class-F RF CMOS amplifier. In the amplifier, an electric current flow is adjusted between a drain and source of an N-channel MOS (NMOS) transistor M5 by using an inverter 20 with an NMOS transistor M3 and a P-channel MOS (PMOS) M4 simply balanced and by using an output of the inverter 20 as a gate voltage Vg.

When the CMOS inverter 20 of the basic structure without an additional passive device is used as a switching driver, it is used for the high efficiency class-F amplifier and the pre-amplifier for transforming an input signal of the RF power amplifier into a signal with a suitable duty cycle and magnitude. In this case, the inverter does not operate correctly at a duty ratio of 50% due to various environmental factors such as a mismatch, a process variation, a temperature variation in operation, and so on. Also, an additional external bias voltage (not illustrated) is to be added to an input terminal.

The conventional pre-power amplifiers or drivers basically require an external bias voltage to compensate an initial duty ratio in various external environments. Miniaturization is difficult because an additional structure (e.g., a temperature compensation circuit and so on) may be required to adjust the external bias voltage for compensating for duty ratio distortion due to continuously varying factors when a circuit operates under external environments. In most cases, a fixed external bias voltage is used for miniaturization even though the efficiency is reduced due to the duty ratio distortion.

When the duty ratio of an output signal does not become 50% for various reasons, the efficiency of the amplifier is abruptly lowered. Thus, additional circuits for the external bias voltage and compensation for various environmental variations are provided in the conventional technologies to maintain the duty ratio of 50%. In this case, a structure of the additional circuits can be a burden and some efficiency loss can occur because the duty ratio is not stably maintained.

## SUMMARY OF THE INVENTION

Accordingly, the present invention has been designed to solve the above and other problems occurring in the prior art. Therefore, it is an object of the present invention to provide a high efficiency power amplifier that has a precise duty cycle in multi-stage Metal Oxide Semiconductor (MOS) inverters including a MOS inverter in which a feedback part is added to maintain a duty cycle at high efficiency while actively coping with various environmental variations including a mismatch, process variation, and temperature variation.

In accordance with an aspect of the present invention, there is provided a high efficiency power amplifier with an inverter configured by one pair of Metal Oxide Semiconductor (MOS) transistors, including a feedback path for adjusting an input voltage in response to an output voltage between input and output terminals of the inverter and correcting an operation time point of the MOS transistors configuring the inverter.

The feedback path between the input and output terminals of the inverter is formed by a resistor connected in parallel.

A stage subsequent to the inverter with the feedback path has at least one inverter with or without the feedback path.

## BRIEF DESCRIPTION OF THE DRAWINGS

The above and other objects and aspects of the present invention will be more clearly understood from the following detailed description taken in conjunction with the accompanying drawings, in which:

FIG. 1 is a circuit diagram illustrating a structure of a conventional power amplifier;
FIG 2 is a circuit diagram illustrating a structure of another conventional power amplifier;
FIG. 3 is a circuit diagram illustrating a structure of a power amplifier in accordance with the present invention;
FIG. 4 is a waveform diagram illustrating an example of output duty cycles of the conventional power amplifier;
FIG. 5 is a waveform diagram illustrating an operation when the present invention is applied;
FIGS. 6A to 6B are waveform diagrams illustrating a relation between a duty cycle and efficiency of the amplifier;
FIGS. 7 and 8 are graphs illustrating simulation results of a duty variation of the conventional power amplifier; and
FIGS. 9 and 10 are graphs illustrating simulation results of a duty variation of the power amplifier of the present invention.

## DETAILED DESCRIPTION OF THE PREFERRED EMBODIMENTS

Preferred embodiments of the present invention will be described in detail herein below with reference to the accompanying drawings.

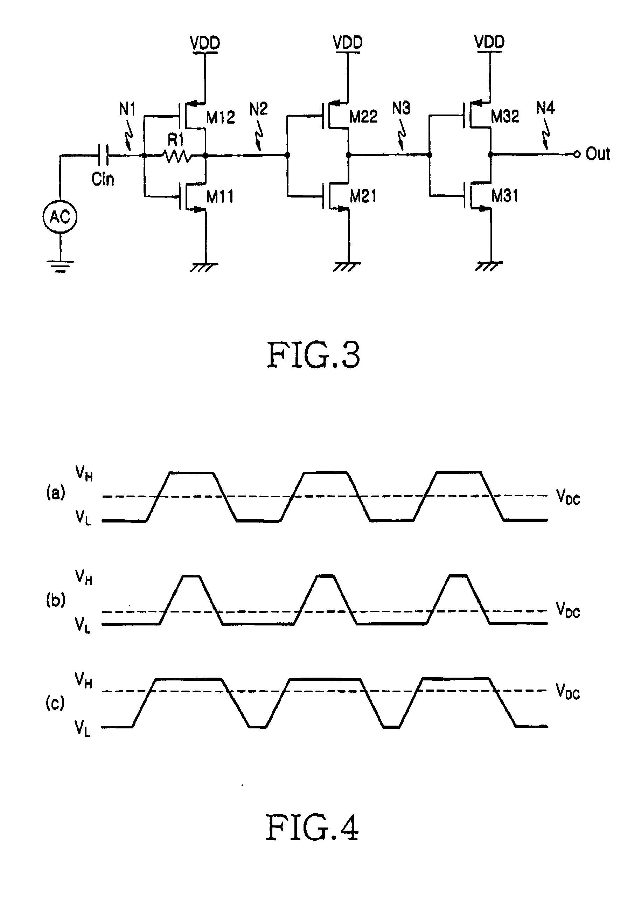

FIG. 3 is a circuit diagram illustrating a structure of a power amplifier in accordance with the present invention. As illustrated in FIG. 3, gates of an N-channel Metal Oxide Semiconductor (MOS) (NMOS) transistor M11 and a P-channel MOS (PMOS) transistor M12 are connected to each other and are used as input terminals. Drains of the NMOS transistor M11 and the PMOS transistor M12 are connected to each other and are used as output terminals. The MOS inverters have a structure in which sources are connected to a power supply voltage and ground. The MOS inverters are connected in three stages. PMOS transistors M12, M22, and M32 and NMOS transistors M11, M21, and M31 configuring the respective inverters are designed to maintain a maximal output duty ratio of 50% using well-balanced transistors. According to features of the present invention, a feedback resistor R1 is connected between input and output terminals of a first inverter stage in order to actively set the duty ratio varying with various environmental variables to 50%.

The first inverter stage with the feedback resistor R1 switches an input signal to a square wave of the power supply voltage and the ground voltage, thereby compensating for the distortion of an output duty cycle caused by environmental variables such as a mismatch, process variation, temperature variation and so on between the MOS transistors configuring the inverter. That is, the feedback resistor R1 uses a voltage to be output to an output node N2, which is higher than that of an input node N1, as a bias voltage, and applies the voltage to the input node N1, such that an input voltage to be applied to the input node N1 is varied by an output voltage. This feedback of the output voltage prevents the MOS transistors N11 and N12 from generating a distorted output voltage in response to the input voltage in the characteristics of the inverter in which the polarity is inverted.

The inverters connected to the subsequent stages do not include a feedback resistor R1, and increase an output level using the output of the first inverter stage for providing a precise duty output of 50%. When a single inverter for supplying a desired output is designed in place of the multi-stage structure of the inverters, the input impedance significantly increases. In the multi-stage structure, the first stage is configured with MOS transistors of a relatively small size, to decrease the input impedance. In contrast, the second stage is configured with MOS transistors of a relatively large size to allow a relatively large amount of electric current to flow, and the third stage is configured with MOS transistors of a larger size, such that a desired target output can be provided.

In the structure of FIG. 3, the feedback resistor R1 is configured only in the first stage. Alternatively, the feedback resistor R1 can be also configured in the second or third stage. In this case, however, the efficiency is lowered. Even though the subsequent inverters using the input corresponding to the output of the first stage for transforming a sine wave into a square wave are further provided with the feedback resistor, the efficiency improvement is small. Thus, it is preferred that the feedback resistor R1 is configured only in the first stage.

FIG. 4 is a waveform diagram illustrating situation-by-situation outputs of inverters configured by simply balanced MOS transistors without the above-described feedback resistor R1 in the structure of FIG. 3. In FIG. 3, the average output is indicated by a Direct Current (DC) voltage level. In this case, an external bias voltage is to be supplied to an input terminal of the first inverter.

First, FIG. 4(a) illustrates an ideal case representing an output in a duty cycle of 50:50. In this case, a DC voltage $V_{Dc}$ becomes ½($V_H$ - $V_L$), such that the highest efficiency is provided. In an actual case, however, it is difficult for an initial duty cycle to be 50:50 due to a mismatch or process variation. Duty cycle distortion due to temperature variation occurring in operation cannot be completely prevented even though an external bias voltage is applied in order to overcome such a difficulty. For this reason, output waveforms as illustrated in FIGS. 4(b) and 4(c) appear.

FIG. 4(b) is a waveform diagram in which the duty ratio is less than 50% when an operating rate of the PMOS transistor configuring the inverter is slow and an operating rate of the NMOS transistor is fast. For convenience of explanation, the waveform slightly different from an actual waveform is illustrated in FIG. 4(b).

As illustrated in FIG. 4(b), a DC voltage $V_{DC}$ corresponding to the average voltage is lowered and the efficiency is significantly reduced when an output time of a high voltage $V_H$ to be output in the operation of the PMOS transistor is shorter than that of a low voltage $V_L$ to be output in the operation of the NMOS transistor.

FIG 4(c) is a waveform diagram in which the duty ratio is more than 50% when an operating rate of the NMOS transistor configuring the inverter is slow and an operating rate of the PMOS transistor is fast. For convenience of explanation, the waveform slightly different from an actual waveform is illustrated in FIG. 4(c).

As illustrated in FIG. 4(c), a DC voltage $V_{DC}$ is raised and the efficiency is significantly reduced when an output time of a high voltage $V_H$ to be output in the operation of the PMOS transistor is longer than that of a low voltage $V_L$ to be output in the operation of the NMOS transistor.

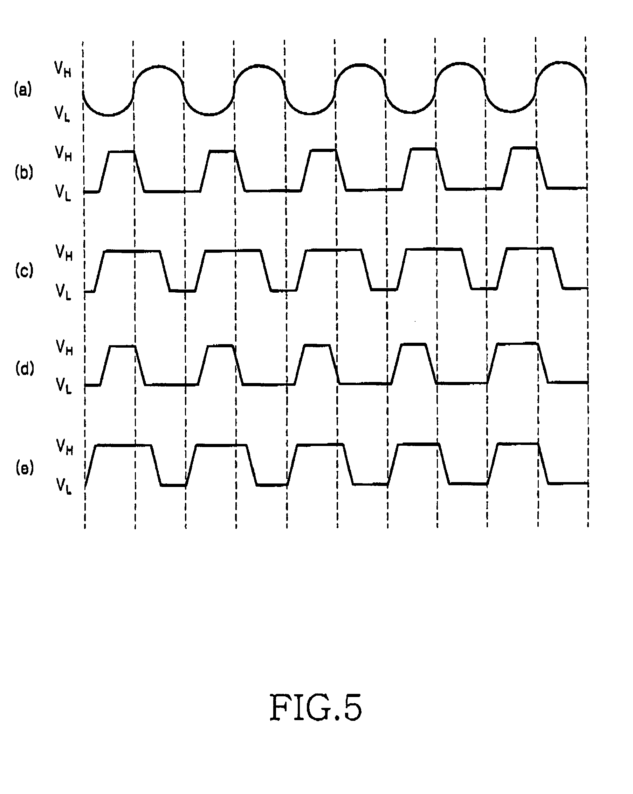

FIG. 5 illustrates output waveforms in a process for compensating for distortion when the feedback resistor R1 is connected between input and output terminals of the inverter to compensate for the duty cycle distortion as illustrated in FIGS. 4(b) and 4(c). In FIG. 5, a compensation relation between the input and output should be noted.

First, an input signal as illustrated in FIG. 5(a) is a sine wave whose duty ratio is 50%. When the input signal passes through the inverter, it is transformed into a square wave whose duty ratio is 50% in an ideal case. However, the duty ratio distortion occurs as illustrated in FIGS. 5(b), and 5(c).

FIG. 5(b) illustrates the case where the operation of the PMOS transistor is slow and the operation of the NMOS transistor is fast. Even though the input signal is applied at the duty ratio of 50%, an output time of a high voltage signal is relatively short and an output time of a low voltage signal is relatively long. When the feedback resistor R1 is connected between the input and output terminals, an output signal whose voltage and current are high as illustrated in FIG. 5(d) is fed back to the input node N1 through the feedback resistor R1, such that the input voltage is varied and therefore an output is corrected.

Next, the influence of an input voltage variation according to the feedback of the output voltage will be described.

The output of the MOS transistors driven by the input signal has a polarity opposite to that of the input signal. When the fed-back output signal and the input signal are the same as each other (or when the input and output signals have the same polarity due to the distortion), an operation of the MOS transistor for generating an output of the opposite polarity is inactivated and an operation of the MOS transistor for generating an output of the same polarity is activated. The inverter operates such that the input and output have opposite polarities. This means that an operation is performed to correct the distortion when distortion occurs. Thus, the distorted duty ratio is set to 50%. At this time, a resistance value of the feedback resistor R1 becomes a criterion for correcting an output signal according to sensitivity and deviation levels. A designer sets an optimal resistance value according to a ratio of voltage and current magnitudes of the input and output signals.

For example, when the duty cycle is distorted since the operation of the PMOS transistor is slow and the operation of the NMOS transistor is fast as illustrated in FIG. 5(b), the output is maintained in a low voltage state because a high voltage is not immediately generated due to the slow operation of the PMOS transistor, despite the fact that the output voltage must be high when the input voltage is low. At this time, the input voltage coupled through the feedback resistor R1 is pulled down by the low output voltage coupled through the feedback resistor R1, such that an amount of electric current across the PMOS transistor increases. As an amount of electric current across the NMOS transistor decreases, the output voltage becomes high.

In contrast, when the duty cycle is distorted since the operation of the NMOS transistor is slow and the operation of the PMOS transistor is fast as illustrated in FIG. 5(c), the output is maintained in a high voltage state because a low voltage is not immediately generated due to the slow operation of the NMOS transistor, despite the fact that the output voltage must be low when the input voltage is high. In this case, when the feedback resistor R1 is connected, the input voltage coupled through the feedback resistor R1 is pulled up by the high output voltage coupled through the feedback resistor R1, such that an amount of electric current across the NMOS transistor increases. As an amount of electric current across the PMOS transistor decreases, the output voltage becomes low.

Thus, if an output switching voltage affects an input switching voltage and the average output voltage becomes ½($V_H$- $V_L$), it means that the duty ratio is 50%. When an output duty ratio is distorted due to various environmental variables in the inverter configured by PMOS and NMOS transistors with different characteristics, an internal feedback path is used for an adaptive bias voltage without an additional external bias voltage. Thus, the output is corrected such that the duty ratio of 50% is correctly maintained.

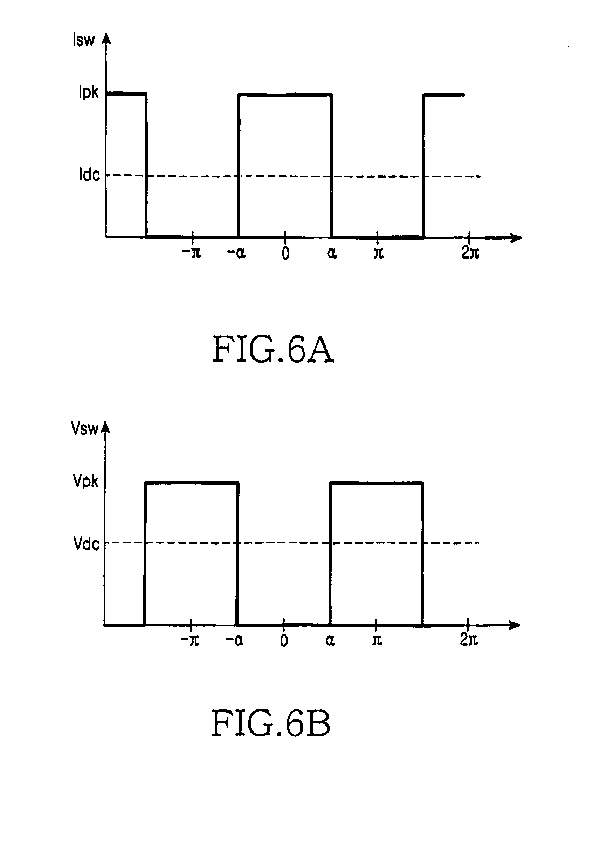

FIGS. 6A and 6B illustrate variations in efficiency according to distortion of the duty ratio. The efficiency of a switching amplifier representing output is defined by the following equations.

First, an output power value capable of being computed through a DC value and a DC voltage value of an output with the waveform as illustrated in FIG. 6, is defined in Equation (1).

$$P = V_{dc} \cdot I_{dc} \cdot \frac{2\sin^2 a}{a(\pi - a)} \qquad \text{Equation (1)}$$

Herein, $V_{dc}$ and $I_{dc}$ are defined in Equation (2) as follows.

$$V_{dc} = \frac{1}{\pi}\int_a^\pi V_{PK}\,d\theta, \quad I_{dc} = \frac{a}{\pi}I_{pk} \qquad \text{Equation (2)}$$

The efficiency is defined in Equation (3).

$$\eta = \frac{2\sin^2 a}{a(\pi - a)} \qquad \text{Equation (3)}$$

When the duty ratio is 50%, the efficiency can be computed using Equation (3) as follows.

$$\eta = \frac{2}{\frac{\pi}{2}(\pi - \frac{\pi}{2})} = \frac{8}{\pi^2} \approx 0.8106$$

That is, when the duty ratio is 50%, the efficiency becomes 81.06%. When the duty ratio is not 50%, the efficiency is abruptly lowered.

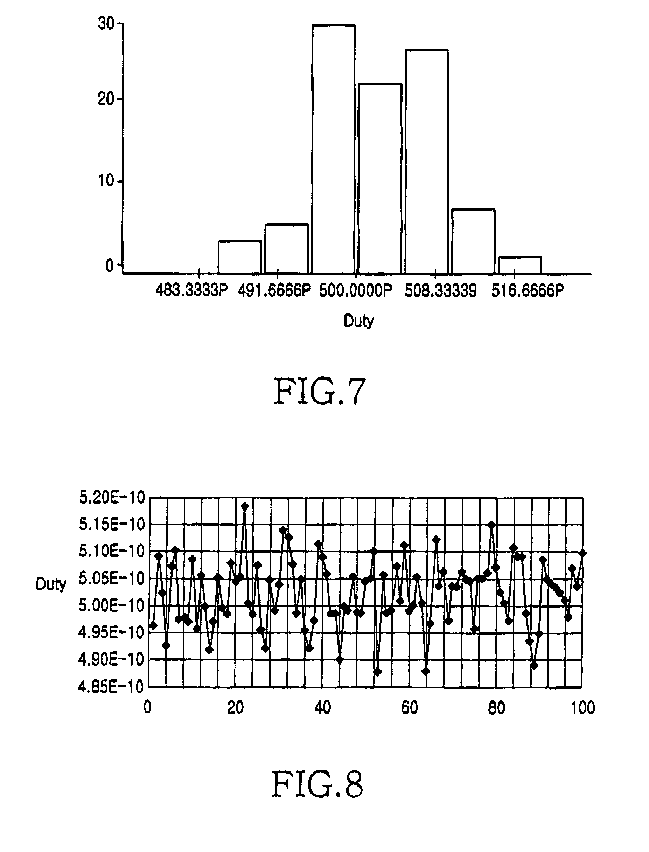

FIGS. 7 and 8 illustrate 100 simulations in Monte Carlo's simulation scheme when an additional external bias voltage is applied in the structure of FIG 3 without the feedback resistor R1. FIGS. 7 and 8 are graphs in which duty variations and variation levels are different under arbitrary environmental variations such as a mismatch, process variation, and so on.

FIG 7 is a bar graph illustrating duty ratio deviations. As illustrated in FIG 7, it can be seen that deviations are widely distributed when the center duty ratio is 50.23% and the standard deviation is 0.608%.

FIG. 8 is a straight-line graph illustrating all simulation results. In FIG. 8, it can be seen that the deviation is significantly large in every simulation. The worst simulation result is the case where the duty ratio is 51.8%. When a temperature variation or another environmental variation is added, a distortion value becomes larger. The output efficiency computed using Equation (3) when the duty ratio is 51.8% is about 1.9% less than the computed output efficiency when the duty ratio is 50%.

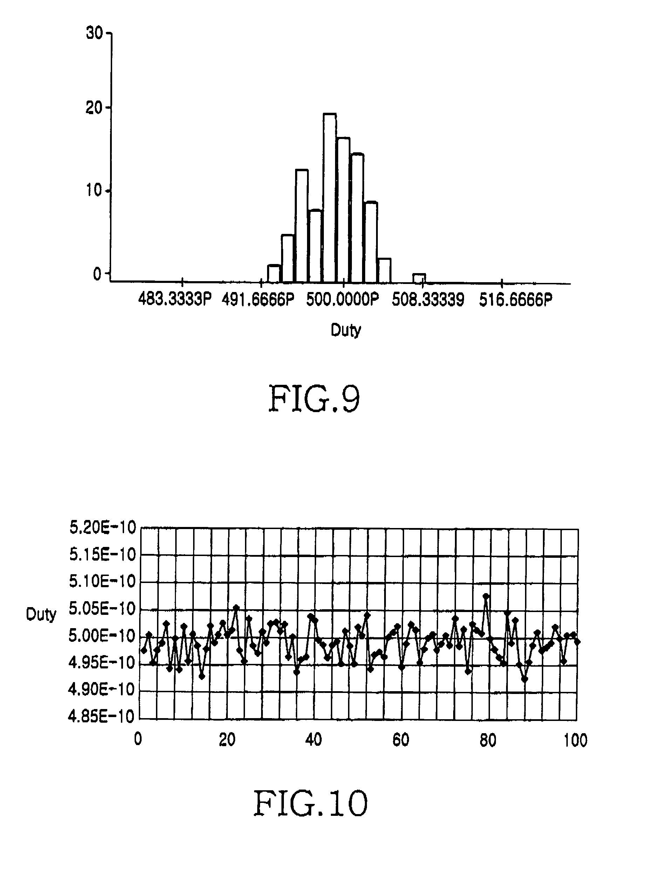

FIGS. 9 and 10 illustrate results in Monte Carlo's simulations using a multi-stage structure in which an external bias voltage is absent as illustrated in FIG. 3, an inverter with a feedback resistor is connected to the first stage, and inverters without the feedback resistor are connected to the second and third stages subsequent to the first stage. FIG. 9 illustrates the degree of variance in the form of a bar graph, and FIG. 10 is a straight-line graph illustrating simulation results representing deviations.

It can be seen that the duty ratio deviation is narrower in the simulation results of FIG. 9 in comparison with the simulation results of FIG. 7. In FIG. 9, it can be seen that the center duty ratio of 49.93% is closer to 50% in comparison with the existing center duty ratio of 50.23% and the standard deviation of 0.297% is the half of the existing standard deviation of 0.608%.

FIG. 10 is a straight-line graph individually illustrating the simulation results of FIG. 9. In FIG. 10, it can be seen that simulation-by-simulation deviations are significantly reduced and many simulation results are concentrated around the duty radio of 50%. This means that an output close to the duty ratio of 50% is provided and therefore the efficiency increases even though various factors capable of distorting the duty cycle occur. In terms of the duty ratio of the worst simulation result, the output efficiency reduction of about 0.03% is smaller than the previous efficiency reduction of about 1.9%.

As described above, when the driver including a CMOS inverter with an additional feedback resistor of the present invention is used, a single driver whose efficiency is high can be easily implemented. When the driver is used for a pre-amplifier of an RF power amplifier, the efficiency of an RF power amplifier can increase.

As described above, according to the present invention, a high efficiency power amplifier with a precise duty cycle includes a MOS inverter with an additional feedback path in order to maintain a high duty cycle at high efficiency while actively coping with various environmental variations including a mismatch, process variation, and temperature variation. The high efficiency power amplifier of the present invention can be used for a high efficiency driver to automatically correct duty cycle distortion. When the high efficiency power amplifier is placed in a front stage of various RF power amplifiers, it can be used as a pre-amplifier capable of increasing the efficiency of the RF power amplifier. The high efficiency power amplifier can be easily implemented without burdens of cost and time because it does not significantly change the existing pre-amplifier structure and does not require complex manufacturing processes.

While the invention has been shown and described with reference to certain preferred embodiments thereof, it will be understood by those skilled in the art that various changes in form and details may be made therein without departing from the spirit and scope of the invention as defined by the appended claims.

## Claims

1. A high efficiency power amplifier with an inverter configured by a pair of Metal Oxide Semiconductor (MOS) transistors, comprising:

   a feedback path for adjusting an input voltage in response to an output voltage between input and output terminals of the inverter and correcting an operation time point of the MOS transistors configuring the inverter.

2. The high efficiency power amplifier of claim 1, wherein the feedback path is formed by a resistor connected between the input and output terminals of the inverter.

3. The high efficiency power amplifier of claim 2, wherein a value of the resistor is set by considering at least one of a ratio of voltage and current magnitudes of input and output signals, an operation variation of the MOS transistors due to external environmental variations, an operating rate, and sensitivity to distortion.

4. The high efficiency power amplifier of claim 1, wherein the output terminal of the inverter with the feedback path is connected to at least one inverter with the feedback path.

5. The high efficiency power amplifier of Claim 1, wherein the output terminal of the inverter with the feedback path is connected to at least one inverter without the feedback path.

FIG.1

FIG.2

FIG.3

FIG.4

FIG.5

## FIG.6A

## FIG.6B

FIG.7

FIG.8

FIG.9

FIG.10

**European Patent Office**

**EUROPEAN SEARCH REPORT**

Application Number

EP 06 01 2404

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 825 708 B1 (DROST ROBERT J ET AL) 30 November 2004 (2004-11-30) * column 4, line 66 - column 6, line 46; figure 2 * | 1-5 | INV. H03F3/217 H03F1/30 H03F1/32 H03F1/34 |
| X | US 6 157 252 A (COMPTON ET AL) 5 December 2000 (2000-12-05) * column 20, lines 12-19; figure 12b * | 1 | |
| A | US 6 049 248 A (GLAS ET AL) 11 April 2000 (2000-04-11) * column 3, lines 11-53; figure 2 * | 1-5 | |
| A | US 6 107 875 A (PULLEN ET AL) 22 August 2000 (2000-08-22) * column 4, line 54 - column 5, line 23; figure 6 * | 1-5 | |
| A | US 2005/035789 A1 (TAMURA HIROTAKA ET AL) 17 February 2005 (2005-02-17) * paragraphs [0090], [0091]; figure 9 * | 1-5 | TECHNICAL FIELDS SEARCHED (IPC) H03F |

The present search report has been drawn up for all claims

| Place of search | Date of completion of the search | Examiner |
|---|---|---|
| The Hague | 13 September 2006 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 01 2404

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2006

| Patent document cited in search report | | Publication date | Patent family member(s) | | Publication date |
|---|---|---|---|---|---|
| US 6825708 | B1 | 30-11-2004 | US | 6753726 B1 | 22-06-2004 |
| US 6157252 | A | 05-12-2000 | AU | 6142999 A | 27-03-2000 |
| | | | CA | 2343322 A1 | 16-03-2000 |
| | | | CN | 1325560 A | 05-12-2001 |
| | | | EP | 1112617 A1 | 04-07-2001 |
| | | | ID | 29454 A | 30-08-2001 |
| | | | WO | 0014870 A1 | 16-03-2000 |
| | | | US | 2001002100 A1 | 31-05-2001 |
| | | | US | 6448852 B1 | 10-09-2002 |
| US 6049248 | A | 11-04-2000 | NONE | | |
| US 6107875 | A | 22-08-2000 | WO | 0022727 A1 | 20-04-2000 |
| US 2005035789 | A1 | 17-02-2005 | NONE | | |

For more details about this annex : see Official Journal of the European Patent Office, No. 12/82